# EUROPÄISCHE PATENTANMELDUNG

(11) **EP 0 542 163 A1**
(43) Veröffentlichungstag der Anmeldung: **19.05.1993**
(21) Anmeldenummer: 92119110.2
(22) Anmeldetag: 07.11.1992
(51) Int. Cl.: H05K 7/14

(54) **Baugruppenträger mit Klemmvorrichtungen**

(30) Priorität: 14.11.1991 DE 4137443
(71) Anmelder: Alcatel SEL Aktiengesellschaft, D-70435 Stuttgart (DE)
(72) Erfinder: KLöpfer, Kurt, W-7015 Korntal (DE); Riedl, Bernd, W-7032 Sindelfingen (DE)
(74) Vertreter: Pohl, Herbert, Dipl.-Ing

(57) **Zusammenfassung**

Zur schock- und vibrationssicheren Fixierung von Leiterplatten in Führungsnuten (4) eines Baugruppenträgers (1) mittels Klemmvorrichtungen (5), sind die im Querschnitt T-artigen Führungsnuten (4) mit Hinterschneidungen versehen. In diese sind die selbsthemmend haltenden Klemmvorrichtungen (5) eingeschoben, welche jeweils aus einer flachen Halteschiene (7) mit einer darauf verschiebbar gelagerten Andruckleiste (8) besteht. Letztere enthält von Zapfen (9) der Halteschiene (7) durchsetzte Schlitze (10), deren Längsachsen sich im spitzen Winkel zur Längsachse der Andruckleiste (8) erstrecken.

Die Andruckleiste (8) wird mit einer ein Langloch in einem Stützlappen (11) der Halteschiene (7) durchsetzenden Betätigungsschraube (13) in Längsrichtung und dabei mittels der Schlitzführung quer dazu verschoben, bis die in eine Ausnehmung (17) der Führungsnut (8) eingeschobene Leiterplatte zwischen der Andruckleiste (8) und einer seitlichen Anlagefläche (18) der Ausnehmung (17) festgeklemmt ist.

## Beschreibung

Die Erfindung betrifft einen Baugruppenträger mit Klemmvorrichtungen nach dem Oberbegriff des Anspruchs 1. Solche Baugruppenträger dienen zur Halterung von Baugruppen, die vorzugsweise aus gedruckten Leiterplatten bestehen und jeweils mittels wenigstens einer Klemmvorrichtung lösbar im Baugruppenträger befestigt werden.

Ein derartiger Baugruppenträger mit Klemmvorrichtungen ist aus der DE 29 20 468 C2 bekannt. Die Seitenwände des als Gehäuse ausgebildeten Baugruppenträgers enthalten Führungsnuten U-förmigen Querschnitts. Jede Führungsnut ist mit einer Klemmvorrichtung bestückt, die aus zwei einen parallelen Abstand voneinander aufweisenden, streifenförmigen Flachstangen besteht, welche durch eine Anzahl schrägstehende Stege gelenkig miteinander verbunden sind. Eine Flachstange ist durch eine mit dem Gehäuse verbundene Betätigungsschraube gegenüber der anderen, sich am Gehäuse und in der Führungsnut abstützenden Flachstange in Längsrichtung verschiebbar, wodurch eine in Richtung der Leiterplatte wirkende Klemmkraft entsteht.

Aus der DE-OS 19 53 363 ist ferner eine Spannvorrichtung bekannt, die aus mehreren, im wesentlichen die ganze Länge einer Führungsnut einnehmenden Druckstücken besteht, welche in einem Winkel zur Längsachse angeordnete Keilflächen haben. Mittels einer Betätigungsschraube sind die Druckstücke divergierend verschiebbar, so daß bei einer ausreichend breiten Führungsnut und darin mittig befestigter Spannvorrichtung, zwischen dieser und den seitlichen Nutwänden je eine Leiterplatte eingeklemmt werden kann.

Der Erfindung liegt die Aufgabe zugrunde, einen Baugruppenträger mit in der Bauhöhe niedriger Klemmvorrichtung zu schaffen, in dem die Klemmvorrichtung zur sicheren Fixierung einer Leiterplatte, an dieser nur eine möglichst minimale Klemmfläche benötigt. Trotzdem soll die Klemmung eine relativ hohe Festigkeit gegen Schock- und Vibrationseinflüsse haben. Diese Aufgabe wird erfindungsgemäß mit den im Anspruch 1 angegebenen konstruktiven Merkmalen gelöst. Weiterbildungen sind den Unteransprüchen zu entnehmen. Die Lösung hat den Vorteil, daß alle Forderungen der gestellten Aufgabe erfüllt sind und die Klemmvorrichtung überdies nur aus sehr wenigen einfachen Einzelteilen besteht, die mit in der Feinwerktechnik üblichen Toleranzen hergestellt und ohne Schwierigkeiten montiert werden können. Deshalb läßt sich die Klemmvorrichtung sehr wirtschaftlich, d.h. mit relativ geringen Herstellkosten, fertigen. Zusätzliche Befestigungsteile sind nicht erforderlich. Obwohl an der Leiterplatte nur eine äußerst kleine Klemmfläche benötigt wird, bewirkt der mit der Klemmvorrichtung erzielbare hohe Anpreßdruck, daß zwischen dem Baugruppenträger und entsprechend metallisierten Flächen auf der Leiterplatte eine Masseankopplung sowie eine gute thermische Ankopplung mit niedrigem elektrischen und thermischen Übergangswiderstand herstellbar ist. Weitere Vorteile sind in der Beschreibung erwähnt.

Die Erfindung wird anhand eines in Zeichnungen dargestellten Ausführungsbeispieles wie folgt näher beschrieben.

In den Zeichnungen zeigen:
- Fig. 1: einen Baugruppenträger mit mehreren Klemmvorrichtungen bestückt, längsgeschnitten;
- Fig. 2: einen Ausschnitt des Baugruppenträgers der Fig. 1 mit darin fixierten Leiterplatten, in Vorderansicht;
- Fig. 3: eine Klemmvorrichtung der Fig. 1, in der Seitenansicht;
- Fig. 4: die Klemmvorrichtung der Fig. 3, in der Draufsicht;
- Fig. 5: einen Baugruppenrahmen mit mehreren Führungsnuten zur Aufnahme einer entsprechenden Anzahl Klemmvorrichtungen, in Vorderansicht.

In den Zeichnungen ist der Baugruppenträger mit 1 bezeichnet. Bei dem dargestellten Ausführungsbeispiel ist er als geschlossenes Gehäuse ausgebildet, das ein rohrförmiges Mittelteil 2 mit im wesentlichen rechteckigem Querschnitt aufweist und dessen offene Stirnseiten durch Abdeckplatten oder -kappen (nicht dargestellt) verschließbar sind. Das vorzugsweise aus Aluminium hergestellte Mittelteil 2 besteht z.B. aus einem einstückigen Druckgußteil, einem abgelängten Stück Strangpreßprofil oder aus zwei zusammengefügten Profilschienen. Der Baugruppenträger 1 kann natürlich auch in unverkleideter Ausführung hergestellt sein, bei der im wesentlichen nur Profilschienen so in horizontaler und vertikaler Lage aneinander befestigt sind, daß sie ein quaderförmiges Rahmengestell mit sich gegenüberliegenden Führungsschienen bilden.

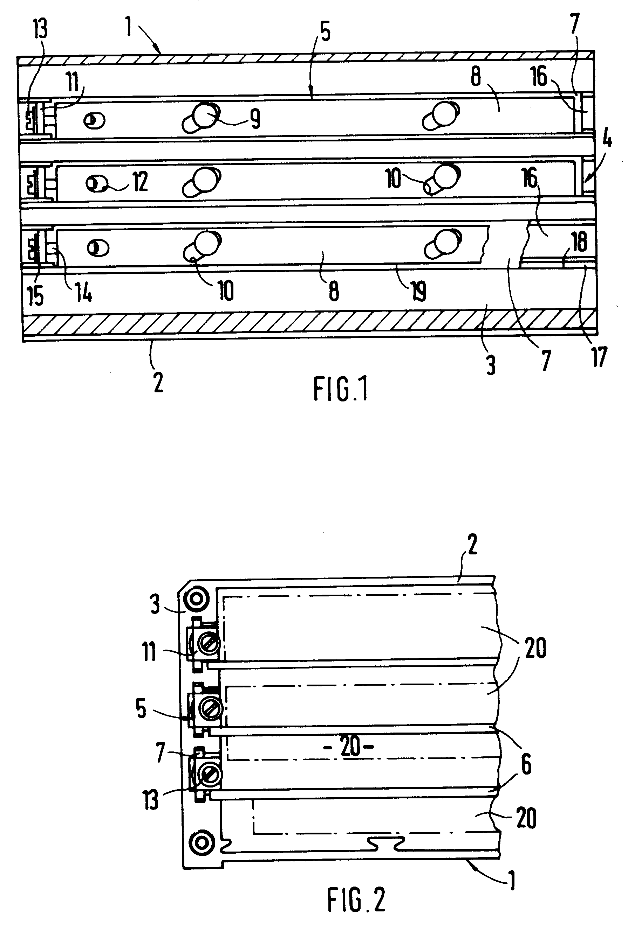

Wie insbesondere Fig. 5 zeigt, hat das Mittelteil 2 des gehäuseförmigen Baugruppenträgers 1 in wenigtens einer, vorzugsweise jedoch in zwei sich gegenüberstehenden Seitenwänden 3 eingelassene Führungsnuten 4, die mit der offenen Nutseite einander zugekehrt sind. Bei der unverkleideten, rahmenförmigen Ausführung des Baugruppenträgers 1 weist jede Führungsschiene wenigstens eine solche Führungsnut 4 auf. Die Führungsnut 4 hat einen hinterschnittenen, T-artigen Querschnitt und sie dient zur Aufnahme einer Klemmvorrichtung 5 sowie zur Führung und Anlage der Längskante einer Leiterplatte 6 bei deren Fixierung(Fig. 2).

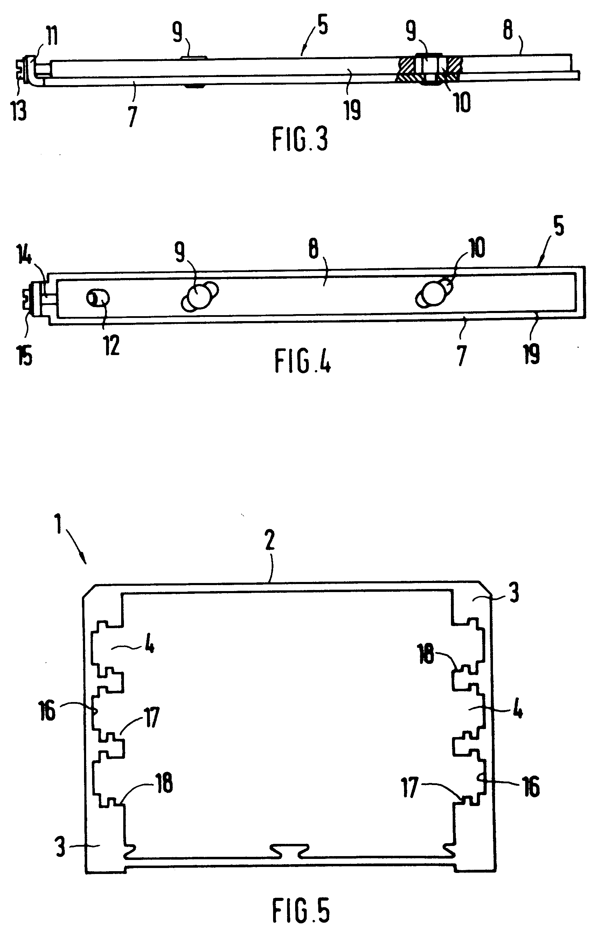

Die in den Fig. 3 und 4 für sich allein dargestellte Klemmvorrichtung 5 besteht im wesentlichen aus einer Halteschiene 7 und einer darauf verschieblich gelagerten Andruckleiste 8, die wenigstens zwei von je einem Zapfen 9 der Halteschiene 7 durchsetzte Schlitze 10 enthält, deren Längsachsen sich im spitzen Winkel zur Längsachse der Andruckleiste 8 erstrecken. Bei der Halteschiene 7 handelt es sich um einen z.B. aus nichtrostendem Stahl bestehenden Blechstreifen rechteckigen Querschnitts, der an einem Ende mit einem rechtwinklig hochgebogenen Stützlappen 11 versehen ist. Dieser Stützlappen 11, der etwas schmaler als die Andruckleiste 8 ist, enthält ein parallel zur Biegekante verlaufendes Langloch.

Die weitgehend plan auf der Halteschiene 7 liegende Andruckleiste 8 hat ebenfalls einen rechteckigen Querschnitt. Sie besteht z.B. aus einem abgelängten Stück Halbzeug, z.B. Flachaluminium oder einem Druckgußteil, ist etwa doppelt so dick wie die Halteschiene 7, jedoch schmaler als diese. Das zum Stützlappen 11 der Halteschiene 7 weisende Ende der Andruckleiste 8 enthält eine Gewindebohrung, die sich von der Stirnseite aus bis zu einer die Andruckleiste 8 durchsetzenden Öffnung 12 erstreckt, welche zur einfacheren Herstellung der Gewindebohrung dient. In letztere ist der Schaft 14 einer von außen durch das Langloch im Stützlappen 11 gesteckten Betätigungsschraube 13 eingedreht und zwar so, daß zwischen dem Stützlappen 11 der Halteschiene 7 und der Andruckleiste 8 noch ein ausreichend großer Verschiebeabstand vorhanden ist. Als Betätigungsschraube 13 dient eine handelsübliche Normschraube mit Rechtsgewinde. Wenn die Klemmvorrichtung 5 für eine häufige Betätigung verwendet werden soll, ist auf dem Schaft 14 zwischen Stützlappen 11 und Andruckleiste 8 beispielsweise eine als Rückstellelement dienende Druckfeder und/oder eine das Herausdrehen der Betätigungsschraube 13 verhindernde Sicherungsscheibe angeordnet (nicht dargestellt).

Durch Drehen der Betätigungsschraube 13 im Uhrzeigersinn wird die Andruckleiste 8 sowohl in Richtung zum Stützlappen 11 als auch quer zur Halteschiene 7 verschoben. Hierbei gleitet der Schraubenschaft 14 im Langloch und der zweckmäßigerweise mit einer Beilegscheibe 15 unterlegte Schraubenkopf an der Außenseite des Stützlappens 11 entlang. Um eine optimale Klemmwirkung zu erreichen, beträgt der Winkel, den die Längsachsen der parallel zueinander angeordneten Schlitze 10 und der Andruckleiste 8 jeweils einschließen, vorzugsweise 30°. Die durch die Schlitze 10 der Andruckleiste 8 ragenden Zapfen 9 sind mit relativ großem Abstand voneinander mittig in der Halteschiene 7 befestigt, beispielsweise durch Nieten oder Umbördeln des hohlen Zapfenendes. Die Zapfen 9 haben einen flachen Kopf, dessen Durchmesser größer als der Schlitz 10 breit ist und verhindern ein Abheben der Andruckleiste 8.

Die T-artige Führungsnut 4 im Baugruppenträger 1 und die Klemmvorrichtung 5 sind im Querschnitt aufeinander abgestimmt, derart, daß letztere mit geringem Druck von einer offenen Stirnseite aus in die Führungsnut 4 eingeschoben werden kann. Hierbei werden die Längskanten der Halteschiene 7 von den seitlichen Hinterschneidungen aufgenommen und geführt, während die Andruckleiste 8 mit relativ großem seitlichen Spielraum im offenen Teil der Führungsnut 4 zu liegen kommt. Damit die Klemmvorrichtung 5 sich in der Führungsnut 4 selbsthemmend halten kann, ist die Halteschiene 7 in einem oder beiden Endbereichen zwischen Zapfen 9 und Schienenende geringfügig abgebogen, wodurch sie vertikal federt und Dickentoleranzen sowohl der Halteschiene 7 als auch der Führungsnut 4 ausgleicht. Sind die Zapfen 9, wie bei dem in den Zeichnungen dargestellten Ausführungsbeispiel erkennbar ist, so in der Halteschiene 7 befestigt, daß an der Unterseite Material hervorsteht, weist der Nutengrund eine ausreichend groß dimensionierte Vertiefung 16 auf, die bei anderen, kein hervorstehendes Material erfordernden Befestigungsarten entfallen kann. Davon unabhängig hat die Führungsnut 4 in jedem Fall an einer Seitenwand eine die Nutöffnung verbreiternde, stufenförmige Ausnehmung 17, welche die eigentliche Aufnahme für die Leiterplatte 6 bildet, da deren Grund die Längskante der Leiterplatte 6 beim Einschieben führt und dieser seitlich als Anlagefläche 18 dient (Fig. 1 und 5).

Sind die Führungsnuten 4 mit unbetätigten Klemmvorrichtungen 5 bestückt und von einer offenen Seite her Leiterplatten 6 lose in den Baugruppenträger 1 eingeschoben, werden die Leiterplatten 6 durch Drehen der Betätigungsschrauben 13 dadurch fixiert, daß schmale Randbereiche der Leiterplatte 6 jeweils zwischen einer Längsseite 19 der Andruckleiste 8 und der komplementären Anlagefläche 18 in der Führungsnut 4 fest eingeklemmt werden. Beim Drehen der Betätigungsschrauben 13 und dem hierdurch bewirkten Anpressen der Andruckleiste 8 an die Leiterplatte 6, verspannen sich gleichzeitig die Halteschienen 7 in den Führungsnuten 4 so fest, daß die Klemmvorrichtungen 5 darin unverrückbar und die Leiterplatte 6 stoß- und vibrationsfest gehalten werden. Durch Linksdrehen der Betätigungsschrauben 13 werden die Fixierungen wieder gelöst.

In Anpreßrichtung der Klemmvorrichtungen 5 wirkende Toleranzen, die bei Herstellung und Anordnung von Zapfen 9 und Schlitzen 10 entstehen und auch im Profil der Führungsnuten 4 vorhanden sind, werden durch eine besondere Form der Halteschiene 7 ausgeglichen. Aus diesem Grund verlaufen die schmalen Längsseiten der Halteschienen 7 von einem kurzen Mittelteil mit parallelen Längsseiten ausgehend in Richtung beider Enden etwas konisch zueinander. Diese Ausbildung gestattet der Halteschiene 7 bei auftretendem Klemmdruck eine geringe elastische Verformung, die eine mechanisch besonders feste Verspannung in der Führungsnut 4 bewirkt und gleichzeitig dafür sorgt, daß die Andruckleiste 8 auf ganzer Länge mit annähernd gleich hoher Kraft an die Leiterplatte 6 gepreßt wird. Die Verspannung verhindert außerdem ein Selbstlösen der Klemmvorrichtung 5, die zur sicheren Fixierung der Leiterplatte 6 nur eine äußerst kleine Klemmfläche benötigt. Sind beispielsweise die Halteschiene (7) 2 mm und die Andruckleiste (8) 4 mm dick und beträgt der Abstand zwischen Hinterschneidung und Ausnehmung 17 der Führungsnut (4) 1,5 mm, wird zur sicheren Fixierung der Leiterplatte 6, an dieser nur ein 2,5 mm breiter Streifen benötigt. Dieser geringe Flächenbedarf gestattet einen hohen Ausnutzungsgrad der Leiterplatte 6, die sowohl einseitig als auch beiseitig mit Bauelementen bestückt sein kann. Der Bestückungsraum 20 ist in Fig. 2 durch strichpunktierte Linien angedeutet.

## Patentansprüche

1. Baugruppenträger mit Führungsnuten für einschiebbare Baugruppen, insbesondere gedruckte Leiterplatten, die mittels Betätigungsschrauben von in den Führungsnuten angeordneten Klemmvorrichtungen fixierbar sind, von denen jede aus einer einen rechteckigen Querschnitt aufweisenden Halteschiene und einer an dieser verschieblich gelagerten Andruckleiste rechteckigen Querschnitts besteht,
**dadurch gekennzeichnet,** daß die Führungsnut (4) mit zwei die Längskanten der Halteschiene (7) aufnehmenden Hinterschneidungen versehen ist, daß die Halteschiene (7) und die gegenüber der Halteschiene (7) schmalere Andruckleiste (8) im wesentlichen plan aneinander liegen und daß die Andruckleiste (8) von Zapfen (9) der Halteschiene (7) durchsetzte Schlitze (10) enthält, deren Längsachsen sich im spitzen Winkel zur Längsachse der Andruckleiste (8) erstrecken.

2. Baugruppenträger mit Klemmvorrichtung nach Anspruch 1, dadurch gekennzeichnet, daß die Halteschiene (7) an einem Ende einen hochgebogenen Stützlappen (11) aufweist und daß das zum Stützlappen (11) gerichtete Ende der Andruckleiste (8) eine Gewindebohrung enthält, in welche die ein Langloch des Stützlappens (11) durchsetzende Betätigungsschraube (13) eingedreht ist.

3. Baugruppenträger mit Klemmvorrichtung nach Anspruch 2, dadurch gekennzeichnet, daß zwischen dem Stützlappen (11) der Halteschiene (7) und der Andruckleiste (8) auf dem Schaft (14) der Betätigungsschraube (13) eine Druckfeder angeordnet ist.

4. Baugruppenträger mit Klemmvorrichtung nach Anspruch 2, dadurch gekennzeichnet, daß unmittelbar hinter dem Stützlappen (11) auf dem Schaft (14) der Betätigungsschraube (13) eine Sicherungsscheibe angeordnet ist.

5. Baugruppenträger mit Klemmvorrichtung nach Anspruch 1, dadurch gekennzeichnet, daß die Halteschiene (7) in wenigstens einem Endbereich zwischen Zapfen (9) und Schienenende eine Abbiegung zum Toleranzausgleich in den Hinterschneidungen der Führungsnut (4) aufweist.

6. Baugruppenträger mit Klemmvorrichtung nach Anspruch 1, dadurch gekennzeichnet, daß die Längsseiten der Halteschiene (7) von einem Mittelteil mit parallelen Längsseiten ausgehend in Richtung beider Enden konisch zueinander verlaufen.

7. Baugruppenträger mit Klemmvorrichtung nach Anspruch 1, dadurch gekennzeichnet, daß die Längsachsen der Schlitze (10) und die Längsachse der Andruckleiste (8) jeweils einen Winkel von 30° einschließen.

8. Baugruppenträger mit Klemmvorrichtung nach Anspruch 1, dadurch gekennzeichnet, daß die Führungsnut (4) an einer Seitenwand eine Ausnehmung (17) hat, zwischen deren Anlagefläche (18) und der Längsseite (19) der Andruckleiste (8) die Leiterplatte (6) festklemmbar ist.

9. Baugruppenträger mit Klemmvorrichtung nach Anspruch 8, dadurch gekennzeichnet, daß die Führungsnuten (4) in den Seitenwänden (3) eines Druckguß- oder eines Stangpreßprofilteiles (Mittelteil 2) angeordnet sind.

10. Baugruppenträger mit Klemmvorrichtung nach Anspruch 1, dadurch gekennzeichnet, daß die bei unverkleideten Baugruppenträgern (1) verwendeten Führungsschienen jeweils wenigstens eine mit einer Klemmvorrichtung (5) bestückte Führungsnut (4) enthalten.
